# EUROPEAN PATENT SPECIFICATION

(11) **EP 3 832 869 B1**
(45) Date of publication and mention of the grant of the patent: **23.02.2022**
(21) Application number: 19213715.6
(22) Date of filing: 05.12.2019
(51) Int. Cl.: H02M 3/157, H02M 1/00, G01R 15/12, G01R 31/28

(54) **POWER SUPPLY UNIT WITH ADAPTIVE FEEDBACK CONTROL LOOPS**
STROMVERSORGUNGSEINHEIT MIT ADAPTIVEN RÜCKKOPPLUNGSREGELSCHLEIFEN
UNITÉ D'ALIMENTATION ÉLECTRIQUE COMPORTANT DES BOUCLES DE COMMANDE DE RÉTROACTION ADAPTATIVE

(43) Date of publication of application: 09.06.2021
(73) Proprietor: Rohde & Schwarz GmbH & Co. KG, 81671 München (DE)
(72) Inventor: Weigell, Philipp, 82065 Baierbrunn (DE); Schuetz, Andreas, 63791 Karlstein (DE); Waldschmitt, Juergen, 63933 Mönchberg (DE); Kunisch, Sascha, 63808 Haibach (DE)
(74) Representative: Rupp, Christian

(56) References cited:
- EP-A2- 0 339 551
- CN-B- 106 300 966
- DE-A1- 19 545 531
- DE-A1-102014 223 377
- JP-A- 2011 139 594
- US-A- 3 769 568
- US-A1- 2001 043 079
- US-A1- 2013 221 875

## Description

The present invention relates to a power supply unit, preferably for a power analyzer, a method for operating a power supply unit and a power analyzer comprising a power supply unit, wherein the power supply unit comprises a feedback control unit for selectively controlling the output level of the voltage or the output level of the current to output terminals of the power supply unit on a preset value, and means for sensing the actual output level of the voltage and current, respectively, and sending a signal representing the sensed output level to the feedback control unit.

A power supply or a power supply unit is a device or assembly for supplying power to devices or assemblies, like an electrical or electronic load, that requires different voltages and currents than those provided by a source, like mains supply or batteries. Some power supply units are separate, standalone pieces of equipment, while others are built into the load appliances that they power. Power supply units are also referred to as electric power converters, since the main function of a power supply unit is to convert electric current from the source to the correct voltage, current and/or frequency to power the connected electric load.

Power supply units are used in and for a great variety of different electric and electronic devices. One of them are power analyzers. A power analyzer is used to measure the flow of power in an electrical system. Power analyzers are able to measure a variety of parameters associated to power consumption and generation. Power analyzers are used for measuring a host of aspects of electrical power for applications, which include testing power electronics, inverters, motors and drives, lighting, home appliances, office equipment, industrial machinery and more.

Power supply units are categorized in various ways. One type of a power supply unit is a DC power supply unit, wherein the most common one is a switched-mode power supply (SMPS). The SMPS is powered from a DC source or from an AC source and supplies constant DC voltage to its load. In a SMPS the AC mains input is directly rectified and then filtered to obtain a DC voltage. The resulting DC voltage is then switched on and off at a higher frequency by electronic switching, thus producing an AC current that will pass through a high frequency transformer or inductor. After the inductor or transformer secondary, the high frequency AC is rectified and filtered to produce the DC output voltage.

A SMPS is for example described in the EP 2 659 578 A2. From there, it is derivable that an uncontrolled source of voltage (or current, or power) is applied to the input of a power system with the expectation that the voltage (or current, or power) at the output will be very well controlled, wherein the basis of controlling the output is to compare it to some form of reference, and any deviation between the output and the reference becomes an error. In this document beneath others a feedback control is described, wherein negative feedback is used to reduce an error to an acceptable value, as close to zero as is required by the system.

Another power supply is described in the EP 1 853 985 A2, which comprises a voltage control loop and a current control loop. In more detail, from this document a power supply circuit is known that includes two pass transistors that conduct current from a voltage supply terminal to an output terminal, wherein one of the pass transistors is smaller whereas the other is larger. In this document, current through the smaller transistor is controlled by the voltage control loop such that the voltage on the output terminal is regulated to a predetermined voltage, and current through the larger transistor is controlled by a high gain current control loop such that the current flowing through the larger transistor is a multiple of the current flowing through the smaller pass transistor.

The document JP 2011 139594 A shows a power supply, able to operate either in a sustained operation mode or a changing operation mode. Different control loops are used for the two different operation modes.

The document DE 195 45 531 A1 shows a power supply, which has a voltage mode and a current mode. An automatic selection, which of the modes to operate the power supply with, is performed.

The document EP 0 339 551 A2 shows a power supply, especially for welding devices. The power supply operates either any voltage control mode or a power control mode. The user selects between these two.

The document US 3 769 568 A shows a power supply, especially a DC-DC converter. Also here, an operation and a voltage control mode and a power control mode is possible.

The document DE 10 2014 223377 A1 shows a power supply, which comprises a voltage control loop and a current control loop. The power supply autonomously switches between the use of either of these.

A problem that can arise in the above-described power supply units or generally in power supply units with at least two control loops/feedback control loops, for example a voltage control loop and a current control loop, is that depending on which one of the control loops is selected/prioritized, there is a risk that in the other control loop respectively the other variable (the voltage or the current) a transient overshoot/oscillation occurs, which could even destroy the load or the device under test (DUT) connected to the power supply unit.

In general, when a stationary process is excited by a change (like a load change or connecting a load to the power supply unit) a free oscillation occurs and, as a result of damping (according to, for example, feedback control), a new stationary process decays (oscillating) or becomes aperiodic (creeping).

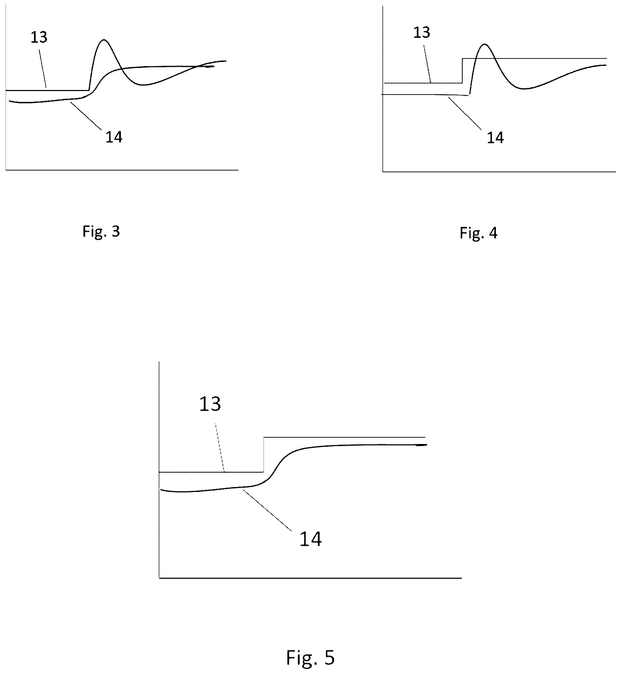

A transient overshoot/oscillation can for example arise when the load or the DUT connected to the power supply unit varies or a load or DUT is connected to the power supply unit, due to necessary adjustment processes. Such a transient overshoot/oscillation is for example shown in the figures 3 and 4, wherein in fig. 3, a transient overshoot of the voltage 13, respectively a voltage transient oscillation, is shown, whereas in Fig. 4, a transient overshoot of the current 14, respectively a current transient oscillation, is shown.

Presently, such problems are addressed by manual selection of the priority of one of the feedback control loops.

It is an object of the present invention to provide a power supply unit that avoids transient overshoots or oscillations when, for example, a new load or DUT is connected to the power supply unit or the load or DUT is varied, without a manual selection of a priority of a feedback control loop.

This object is achieved by means of the features of the independent claims. The dependent claims further develop the central idea of the present invention.

The present invention relates to a power supply unit, as set forth in claim 1, preferably for a power analyzer, comprising a feedback control unit arranged for selectively controlling the output level of the voltage or the output level of the current to output terminals of the power supply unit on a preset value, and means for sensing the actual output level of the voltage and current, respectively, and sending a signal representing the sensed output level to said feedback control unit, wherein the feedback control unit is arranged to autonomously prioritize or activate at least a first control loop for the controlling of the output level of the current or a second control loop for the controlling of the output level of the voltage, based on data generated within the power supply unit and/or externally generated data supplied to the power supply unit, wherein the first control loop and the second control loop are both active and operating, and wherein prioritizing means that one of the first control loop and the second control loop is weighted more strongly than the other one, and thus, has more influence than the other one on the controlling of the power circuit by the feedback control unit.

Advantageously, the externally generated data are data from a DUT or a load connected to the output terminals of the power supply unit, wherein the externally generated data can be sensed data, preferably representing the impedance or the capacitance, of the DUT or load. It is also possible that the externally generated data are data from a database connected to the power supply unit via a network interface of the power supply unit.

In a preferred embodiment, the data generated within the power supply unit are sensor data, preferably representing an electrical parameter, such as voltage, current or power transmission, of the status of the output terminals. It is also possible that the data generated within the power supply unit are data from a database in the power supply unit.

In a preferred embodiment, the data generated within the power supply unit or externally generated data are supplied to an Artificial Intelligence unit, such as a trained network, issuing a selection signal for prioritizing the first or the second control loop, respectively.

The Artificial Intelligence unit can be positioned in the power supply unit or the Artificial Intelligence unit can be externally positioned and the power supply unit is connected to the Artificial Intelligence unit via a network interface of the power supply unit.

In a preferred embodiment, the feedback control unit is furthermore arranged to adjust at least one control parameter value of the prioritized control loop, preferably also based on data generated within the power supply unit or externally generated data supplied to the power supply unit.

Advantageously, the power supply unit is a DC power supply and the feedback control unit comprises an analogue or a digital control algorithm.

The present invention further relates to a power analyzer comprising the above power supply unit.

The present invention further relates to a method for operating a power supply unit, as set forth in claim 13, preferably for a power analyzer, comprising selectively feedback controlling the output level of the voltage or the output level of the current to output terminals of the power supply unit on a preset value, sensing the actual output level of the voltage and current, respectively, for the selectively feedback controlling, and autonomously prioritizing or activating at least a first control loop for the controlling of the output level of the current or a second control loop for the controlling of the output level of the voltage, based on data generated within the power supply unit or externally generated data supplied to the power supply unit, wherein the first control loop and the second control loop are both active and operating, and wherein prioritizing means that one of the first control loop and the second control loop is weighted more strongly than the other one, and thus, has more influence than the other one on the controlling of the power circuit by the feedback control unit.

Advantageously, the method further comprises supplying to an Artificial Intelligence unit, such as a trained network, the data generated within the power supply unit or externally generated data and issuing a selection signal for prioritizing the first or the second control loop, respectively.

In a preferred embodiment, the method further comprises adjusting at least one control parameter value of the prioritized control loop, preferably also based on data generated within the power supply unit or externally generated data supplied to the power supply unit.

With the power supply unit and the method for operating a power supply unit of the present invention, the feedback control unit autonomously prioritizes a voltage control loop or a current control loop, wherein both control loops are monitored to determine which one of the feedback control loops (the current or the voltage) should be activated or should have priority, so that a transient overshoot of the voltage or current or a voltage transient oscillation or a current transient oscillation is avoided or at least reduced, and thus, it is avoided that a load or a DUT connected to the power supply unit is destroyed.

These and other aspects and advantages of the present invention will become more apparent when studying the following detailed description, in connection with the figures in which:
- Figure 1: shows schematically a power supply unit;
- Figure 2: shows schematically another power supply unit;
- Figure 3: shows schematically a diagram of a transient overshoot of a voltage;
- Figure 4: shows schematically a diagram of a transient overshoot of the current; and
- Figure 5: shows schematically a diagram without a transient overshoot of the voltage and the current.

As already described above, a power supply unit, for example used in or for a power analyzer, can have at least two feedback control loops, like a voltage control loop and a current control loop. In case one of the two control loops is prioritized, it could happen that a transient overshoot or a transient oscillation in the variable of the other one occurs. Such transient overshoots or transient oscillations are shown for example in the Figures 3 and 4, wherein Fig. 3 shows a transient overshoot of the voltage 13, whereas in Fig. 4, a transient overshoot of the current 14 is shown. In both cases it could even happen that parts of the power supply unit or the load/DUT connected to the power supply unit are destroyed.

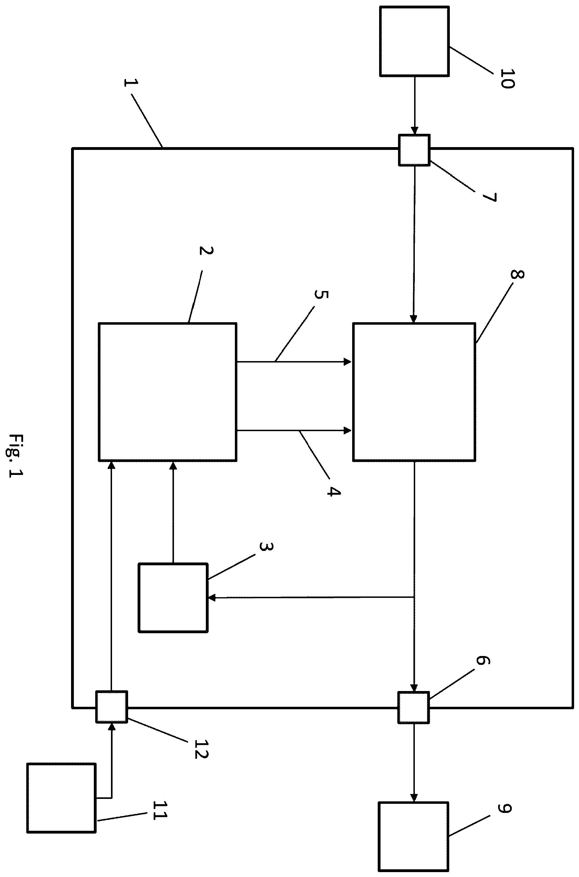

In the present invention both control loops are now monitored and then it is determined, which one of the control loops should be prioritized so that a transient overshoot or a transient oscillation is avoided or at least reduced. Therefore, as shown in figure 1, a power supply unit 1 according to the present invention discloses a feedback control unit 2 selectively controlling the output level of the voltage or the output level of the current to output terminals 6 of the power supply unit 1 on a preset value.

The feedback control unit 2 is connected to a power circuit 8 or power unit, wherein the power circuit 8 converts an electric current from a source 10 connected to input terminals 7 to the correct voltage, current and frequency to power a load 9 connected to the output terminals 6, wherein the power circuit 8 is connected to the input terminals 7 for receiving for example an electric current from the source 10 and is connected to the output terminals 6 for outputting the voltage, the current or the power for the load 9. The power circuit 8 is then controlled by the feedback control unit 2.

The connection between the feedback control unit 2 and the power circuit 8 comprises a part 4 of a current control loop and a part 5 of a voltage control loop, wherein the power circuit 8 is then controlled by the feedback control unit 2 by the current control loop as well as the voltage control loop.

Regarding the load 9, it should be noted that the load 9 can be for example a power analyzer, wherein the power supply unit 1 can be integrated together with the power analyzer in one housing or can be separately provided in an own housing. Further, it is possible that the power supply unit 1 does not only provide to the power analyzer but also to a DUT connected to the power analyzer voltage, current or power. In this case, the load 9 is therefore the power analyzer together with the DUT.

The power supply unit 1 further comprises means 3 for sensing the actual output level of the voltage and current, respectively, and sending a signal representing the sensed output level to said feedback control unit 2. The means 3 for sensing the actual output level are connected to the output of the power circuit 8. With the signaling representing the sensed output level received from the means 3 for sensing the actual output level, the feedback control unit 2 can then selectively control the power circuit 8 via the part 4 of the current control loop and the part 5 of the voltage control loop and thus, control the voltage, the current or the power supplied at the output of the power circuit 8 and thus, at the output terminals 6 for the load 9.

Therefore, as can be also seen from fig. 1, the means 3 for sensing the actual output level, the feedback control unit 2 and the part 5 form a voltage feedback loop/voltage control loop, whereas the means 3 for sensing the actual output level, the feedback control unit 2 and the part 4 form a current feedback loop/current control loop. The means 3 for sensing the actual output level and the feedback control unit 2 are used in both feedback loops/control loops.

According to the present invention, the feedback control unit 2 now autonomously prioritize the first control loop 4 for the controlling of the output level of the current or the second control loop 5 for the controlling of the output level of the voltage, based on data generated within the power supply unit or externally generated data supplied to the power supply unit.

Since the feedback control unit 2 prioritizes the first control loop 4 (current) or the second control loop 5 (voltage) autonomously, transient overshoots or oscillations can be avoided or at least reduced without a manual selection of a priority of one of the control loops 4 or 5, when, for example, a new load 9 or DUT is connected to the power supply unit 1 or the load 9 or DUT is varied. This is derivable for example from fig. 5, where, compared to the fig. 3 and 4, no more transient overshoots or oscillations exist in the voltage (in difference to fig. 3) as well as in the current (in difference to fig. 4).

Prioritizing in the present invention means that one of the control loops 4 or 5 is more weighted than the other one and thus, has more influence than the other one on the controlling of the power circuit 8 by the feedback control unit 2.

The autonomously prioritizing of the first control loop 4 for the controlling of the output level of the current or the second control loop 5 for the controlling of the output level of the voltage by the feedback control unit 2 is done based on data generated within the power supply unit and/or externally generated data supplied to the power supply unit.

The externally generated data can be data from the DUT or the load 9 connected to the output terminals 6 of the power supply unit 1. In particular, it can be sensed data, representing the impedance or the capacitance, of the DUT or load 9. In this case, the impedance or the capacitance of the DUT or load 9 connected to the power supply unit 1 are measured and then transmitted from the DUT or load 9 to the feedback control unit 2 via, for example, a separate connection not shown in detail in fig. 1.

It is also possible that the externally generated data are data from a database. For this, the power supply unit 1 is connected to database 11, wherein the power supply unit 1 comprises a network interface 12 that is used for connecting to the database 11. From the database 11 the externally generated data is then derivable, which are used by the feedback control unit 2 for autonomously prioritizing the first control loop 4 for the controlling of the output level of the current or the second control loop 5 for the controlling of the output level of the voltage. The externally generated data in the database 11 can be for example test sequence data, DUT data, control loop parameters, test parameters or test limits.

Further, it is also possible that the externally generated data are data of a user input, for example via a corresponding input unit connected to the power supply unit 1 or integrated in the power supply unit 1.

The data generated within the power supply unit 1 can be sensor data, preferably representing an electrical parameter, such as voltage, current or power transmission, of the status of the output terminals 6, for example data sensed by the means 3 for sensing the actual output level of the voltage and current.

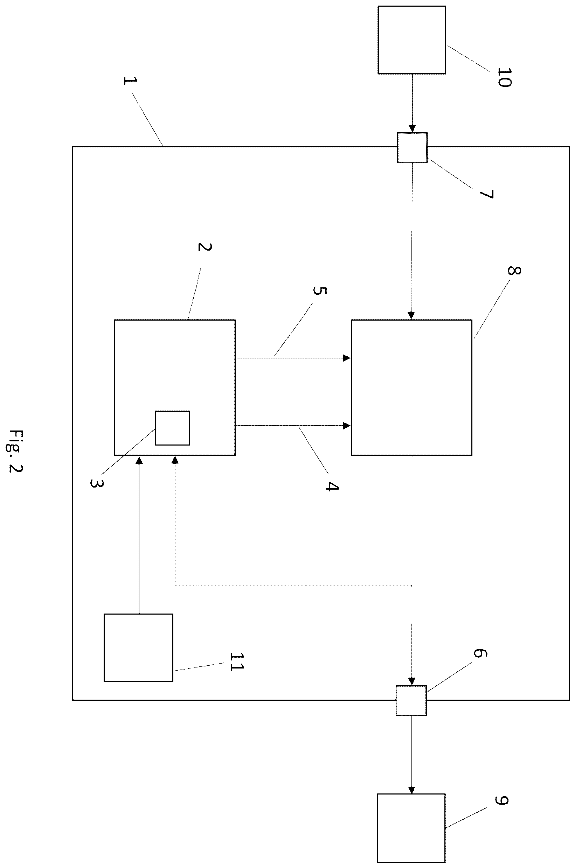

It is also possible that the data generated within the power supply unit 1 are data from a database 11 positioned in the power supply unit 1, as it is shown in fig. 2. From the database 11 in the power supply unit 1 the data is then derivable, which is used by the feedback control unit 2 for autonomously prioritizing the first control loop 4 for the controlling of the output level of the current or the second control loop 5 for the controlling of the output level of the voltage. Similar, the data in the database 11 in the power supply unit 1 can be for example test sequence data, DUT data, control loop parameters, test parameters or test limits.

In the power supply unit 1 shown in fig. 1 the means 3 for sensing the actual output level are positioned separately from the feedback control unit 2.

Alternatively, the means 3 for sensing the actual output level can be placed in the feedback control unit 2, wherein then the feedback control unit 2 is directly connected to the output of the power circuit 8. This is illustrated in fig. 2, which shows a power supply unit 1 similar to that shown in fig. 1, comprising a feedback control unit 2, means 3 for sensing the actual output level, output terminals 6, input terminals 7 and a power circuit 8, wherein the power circuit 8 converts an electric current from a source 10 connected to input terminals 7 to the correct voltage, current and frequency to power a load 9 connected to the output terminals 6. The only difference between the power supply unit 1 in fig. 2 and the power supply unit 1 in fig. 1 is that in the power supply unit 1 in fig. 2 the means 3 for sensing the actual output level are placed in the feedback control unit 2 and the database 11 is placed in the power supply unit 1. Otherwise, the power supply unit 1 in fig. 2 and the power supply unit 1 in fig. 1 work in a similar way.

Further, it would be also possible that the means 3 for sensing the actual output level are placed separately from the feedback control unit 2 as shown in fig. 1 and the database 11 is placed in the power supply unit 1 as shown in fig. 2, or that the means 3 for sensing the actual output level are placed in the power supply unit 1 as shown in fig. 2 and the database 11 is placed separately from the feedback control unit 2 as shown in fig. 1 using the network interface 12.

The data generated within the power supply unit 1 or the externally generated data can be further supplied to an Artificial Intelligence unit (not shown in the figures), such as a trained network, issuing a selection signal for prioritizing the first or the second control loop 4 or 5, respectively. The Artificial Intelligence unit can be positioned in the power supply unit 1 or the Artificial Intelligence unit can be externally positioned and the power supply unit 1 is connected to the Artificial Intelligence unit via the network interface 12 or another network interface of the power supply unit 1.

In the power supply unit 1 according to the present invention, the feedback control unit 2 can use one or any combination of the above described data generated within the power supply unit 1 and the externally generated data for autonomously prioritizing the first control loop 4 for the controlling of the output level of the current or the second control loop 5 for the controlling of the output level of the voltage. Furthermore, the feedback control unit 2 can adjust at least one control parameter value of the prioritized control loop 4 or 5, preferably also based on data generated within the power supply unit 1 or externally generated data supplied to the power supply unit 1.

The power supply unit 1 can also comprise a further third control loop (not shown in the figures), for example for the power, wherein the feedback control unit 2 then autonomously prioritizes the first control loop 4, the second control loop 5 or the third control loop.

The feedback control unit 2 can be for example a microcontroller or microprocessor.

Regarding the load 9, it should be noted that the load 9 can be integrated together with the power supply unit 1 in one housing or the power supply unit 1 can be separately provided in an own housing.

Thus, in the present invention both control loops are monitored and then it is determined which one of the control loops should be prioritized so that a transient overshoot or a transient oscillation is avoided or at least reduced.

## Claims

1. A power supply unit (1), preferably for a power analyzer, comprising:
- a feedback control unit (2) arranged for selectively controlling an output level of a voltage or an output level of a current to output terminals (6) of the power supply unit (1) on a preset value, and
- means (3) for sensing the actual output level of the voltage and current, respectively, and sending a signal representing the sensed output level to said feedback control unit (2),
wherein the feedback control unit (2) is arranged to autonomously prioritize one of at least a first control loop (4) for the controlling of the output level of the current or a second control loop (5) for the controlling of the output level of the voltage, based on data generated within the power supply unit (1) and/or externally generated data supplied to the power supply unit (1),
wherein the first control loop (4) and the second control loop (5) are both active and operating, and
wherein prioritizing means that one of the first control loop (4) and the second control loop (5) is weighted more strongly than the other one, and thus, has more influence than the other one on the controlling of the power circuit by the feedback control unit (2).

2. The power supply unit of claim 1, wherein the externally generated data are data from a device under test, DUT, or a load (9) connected to the output terminals (6) of the power supply unit (1).

3. The power supply unit of claim 2, wherein the externally generated data are sensed data, preferably representing the impedance or the capacitance, of said DUT or load (9).

4. The power supply unit of any of the preceding claims, wherein the data generated within the power supply unit (1) are sensor data, preferably representing an electrical parameter, such as voltage, current or power transmission, of the status of the output terminals (6).

5. The power supply unit of any of the preceding claims, wherein the externally generated data are data from a database (11) connected to the power supply unit (1) via a network interface (12) of the power supply unit (1).

6. The power supply unit of any of the preceding claims, wherein the data generated within the power supply unit (1) are data from a database (11) in the power supply unit (1).

7. The power supply unit of any of the preceding claims, wherein the data generated within the power supply unit (1) or externally generated data are supplied to an Artificial Intelligence unit, such as a trained network, issuing a selection signal for prioritizing the first or the second control loop (4, 5), respectively.

8. The power supply unit of claim 8, wherein Artificial Intelligence unit is positioned in the power supply unit (1) or wherein the Artificial Intelligence unit is externally positioned and the power supply unit (1) is connected to the Artificial Intelligence unit via a network interface (11) of the power supply unit (1).

9. The power supply unit of any of the preceding claims, wherein the feedback control unit (2) is furthermore arranged to adjust at least one control parameter value of the prioritized control loop (4, 5), preferably also based on data generated within the power supply unit (1) or externally generated data supplied to the power supply unit (1).

10. The power supply unit of any of the preceding claims, which is a DC power supply.

11. The power supply unit of any of the preceding claims, wherein the feedback control unit (2) comprises an analogue or a digital control algorithm.

12. A power analyzer comprising a power supply unit (1) according to any of the claims 1-11.

13. A method for operating a power supply unit (1), preferably for a power analyzer, comprising:
- selectively feedback controlling an output level of a voltage or an output level of a current to output terminals (6) of the power supply unit (1) on a preset value,
- sensing the actual output level of the voltage and current, respectively, for the selectively feedback controlling, and
- autonomously prioritizing one of at least a first control loop (4) for the controlling of the output level of the current or a second control loop (5) for the controlling of the output level of the voltage, based on data generated within the power supply unit (1) or externally generated data supplied to the power supply unit (1),
wherein the first control loop (4) and the second control loop (5) are both active and operating, and
wherein prioritizing means that one of the first control loop (4) and the second control loop (5) is weighted more strongly than the other one, and thus, has more influence than the other one on the controlling of the power circuit by the feedback control unit (2).

14. The method of claim 13, further comprising supplying to an Artificial Intelligence unit, such as a trained network, the data generated within the power supply unit (1) or externally generated data and issuing a selection signal for prioritizing the first or the second control loop (4, 5). respectively.

15. The method of claim 13 or 14, further comprising adjusting at least one control parameter value of the prioritized control loop (4, 5), preferably also based on data generated within the power supply unit (1) or externally generated data supplied to the power supply unit (1).

## Patentansprüche

1. Eine Stromversorgungseinheit (1), vorzugsweise für ein Leistungsmessgerät, mit:
- einer Rückkopplungsregelungseinheit (2), die so angeordnet ist, dass ein Ausgangspegel einer Spannung oder ein Ausgangspegel eines Stroms zu den Ausgangsklemmen (6) der Stromversorgungseinheit (1) auf einen voreingestellten Wert selektiv gesteuert wird,
- Mitteln (3) zum Erfassen des tatsächlichen Ausgangspegels der Spannung bzw. des Stroms und zum Senden eines Signals für den erfassten Ausgangspegel an die genannte Rückkopplungsregelungseinheit (2),
wobei die Rückkopplungsregelungseinheit (2) so angeordnet ist, dass mindestens eine erste Regelschleife (4) zur Steuerung des Ausgangspegels des Stroms oder eine zweite Regelschleife (5) zur Steuerung des Ausgangspegels der Spannung, basierend auf den in der Stromversorgungseinheit (1) generierten Daten und/oder den extern generierten Daten, die an die Stromversorgungseinheit (1) übermittelt werden, autonom priorisiert wird,
wobei die erste Regelschleife (4) und die zweite Regelschleife (5) aktiviert und in Betrieb sind, und
wobei Priorisieren bedeutet, dass die erste Regelschleife (4) oder die zweite Regelschleife (5) stärker als die andere gewichtet ist, sodass diese einen größeren Einfluss als die andere auf die Steuerung des Stromkreises über die Rückkopplungsregelungseinheit (2) hat.

2. Die Stromversorgungseinheit nach Anspruch 1, wobei es sich bei den extern generierten Daten um Daten von einer zu prüfenden Vorrichtung, einem Prüfling (DUT) oder einer Last (9) handelt, die an die Ausgangsklemmen (6) der Stromversorgungseinheit (1) angeschlossen sind.

3. Die Stromversorgungseinheit nach Anspruch 2, wobei es sich bei den extern generierten Daten um erfasste Daten, vorzugsweise Impedanz oder Kapazität, des genannten Prüflings oder der Last (9) handelt.

4. Die Stromversorgungseinheit nach einem beliebigen der vorstehenden Ansprüche, wobei es sich bei den in der Stromversorgungseinheit (1) generierten Daten um Sensordaten handelt, die vorzugsweise einen elektrischen Parameter, wie Spannung, Strom oder Leistungsübertragung, des Status der Ausgangsklemmen (6) darstellen.

5. Die Stromversorgungseinheit nach einem beliebigen der vorstehenden Ansprüche, wobei es sich bei den extern generierten Daten um Daten aus einer Datenbank (11) handelt, die über eine Netzwerkschnittstelle (12) der Stromversorgungseinheit (1) an die Stromversorgungseinheit (1) angeschlossen ist.

6. Die Stromversorgungseinheit nach einem beliebigen der vorstehenden Ansprüche, wobei es sich bei den in der Stromversorgungseinheit (1) generierten Daten um Daten aus einer Datenbank (11) in der Stromversorgungseinheit (1) handelt.

7. Das Verfahren nach einem beliebigen der vorstehenden Ansprüche, wobei die in der Stromversorgungseinheit (1) generierten Daten oder die extern generierten Daten an eine Einheit für Künstliche Intelligenz, wie ein trainiertes Netzwerk, übermittelt werden, wobei ein Auswahlsignal zum Priorisieren der ersten bzw. zweiten Regelschleife (4, 5) abgegeben wird.

8. Die Stromversorgungseinheit nach Anspruch 8, wobei sich die Einheit für Künstliche Intelligenz in der Stromversorgungseinheit (1) befindet oder wobei die Einheit für Künstliche Intelligenz extern angeordnet ist und die Stromversorgungseinheit (1) über eine Netzwerkschnittstelle (11) der Stromversorgungseinheit (1) an die Einheit für Künstliche Intelligenz angeschlossen ist.

9. Die Stromversorgungseinheit nach einem beliebigen der vorstehenden Ansprüche, wobei die Rückkopplungsregelungseinheit (2) zudem so angeordnet ist, dass mindestens ein Steuerparameterwert der priorisierten Regelschleife (4, 5) angepasst wird, vorzugsweise ebenfalls basierend auf den in der Stromversorgungseinheit (1) generierten Daten oder den extern generierten Daten, die an die Stromversorgungseinheit (1) übermittelt werden.

10. Die Stromversorgungseinheit nach einem beliebigen der vorstehenden Ansprüche, wobei es sich dabei um ein DC-Netzteil handelt.

11. Die Stromversorgungseinheit nach einem beliebigen der vorstehenden Ansprüche, wobei die Rückkopplungsregelungseinheit (2) einen analogen oder digitalen Steueralgorithmus aufweist.

12. Ein Leistungsmessgerät mit einer Stromversorgungseinheit (1) nach einem der Ansprüche 1 bis 11.

13. Ein Verfahren für den Betrieb einer Stromversorgungseinheit (1), vorzugsweise für ein Leistungsmessgerät, mit:
- selektiver Rückkopplungsteuerung eines Ausgangspegels einer Spannung oder eines Ausgangspegels eines Stroms zu den Ausgangsklemmen (6) der Stromversorgungseinheit (1) auf einen voreingestellten Wert,
- Erfassen des tatsächlichen Ausgangspegels der Spannung bzw. des Stroms für die selektive Rückopplungssteuerung, und
- autonomem Priorisieren mindestens einer ersten Regelschleife (4) zur Steuerung des Ausgangspegels des Stroms oder einer zweiten Regelschleife (5) zur Steuerung des Ausgangspegels der Spannung, basierend auf den in der Stromversorgungseinheit (1) generierten Daten oder den extern generierten Daten, die an die Stromversorgungseinheit (1) übermittelt werden,
wobei die erste Regelschleife (4) und die zweite Regelschleife (5) aktiviert und in Betrieb sind, und
wobei Priorisieren bedeutet, dass die erste Regelschleife (4) oder die zweite Regelschleife (5) stärker als die andere gewichtet ist, sodass diese einen größeren Einfluss als die andere auf die Steuerung des Stromkreises über die Rückkopplungsregelungseinheit (2) hat.

14. Das Verfahren nach Anspruch 13, das weiter das Übermitteln an eine Einheit für Künstliche Intelligenz, wie zum Beispiel ein trainiertes Netzwerk, der in der Stromversorgungseinheit (1) generierten Daten oder der extern generierten Daten sowie die Abgabe eines Auswahlsignals zum Priorisieren der ersten bzw. zweiten Regelschleife (4, 5) umfasst.

15. Das Verfahren nach Anspruch 13 oder 14, das weiter das Anpassen mindestens eines Steuerparameterwerts der priorisierten Regelschleife (4, 5) umfasst, vorzugsweise ebenfalls basierend auf den in der Stromversorgungseinheit (1) generierten Daten oder den extern generierten Daten, die an die Stromversorgungseinheit (1) übermittelt werden.

## Revendications

1. Unité d'alimentation électrique (1), de préférence pour un analyseur de puissance, comprenant :
- une unité de commande de retour (2) agencée pour commander sélectivement un niveau de sortie d'une tension ou un niveau de sortie d'un courant vers des bornes de sortie (6) de l'unité d'alimentation électrique (1) sur une valeur préréglée, et
- des moyens (3) pour détecter le niveau de sortie réel de la tension et du courant, respectivement, et envoyer un signal représentant le niveau de sortie détecté à ladite unité de commande de retour (2),
dans laquelle l'unité de commande de retour (2) est agencée pour accorder la priorité de manière autonome à l'une d'au moins une première boucle de commande (4) pour la commande du niveau de sortie du courant ou d'une deuxième boucle de commande (5) pour la commande du niveau de sortie de la tension, sur la base de données générées dans l'unité d'alimentation électrique (1) et/ou de données générées de manière externe amenées à l'unité d'alimentation électrique (1),
dans laquelle la première boucle de commande (4) et la deuxième boucle de commande (5) sont toutes les deux actives et en fonctionnement, et
dans laquelle l'accord de priorité signifie qu'une de la première boucle de commande (4) et de la deuxième boucle de commande (5) a plus de poids que l'autre, et ainsi, a plus d'influence que l'autre sur la commande du circuit de puissance par l'unité de commande de retour (2).

2. Unité d'alimentation électrique selon la revendication 1, dans laquelle les données générées de manière externe sont des données provenant d'un dispositif sous test, DUT, ou d'une charge (9) connectée aux bornes de sortie (6) de l'unité d'alimentation électrique (1).

3. Unité d'alimentation électrique selon la revendication 2, dans laquelle les données générées de manière externe sont des données détectées, représentant de préférence l'impédance ou la capacité, dudit DUT ou de la charge (9).

4. Unité d'alimentation électrique selon l'une quelconque des revendications précédentes, dans laquelle les données générées dans l'unité d'alimentation électrique (1) sont des données de capteur, de préférence représentant un paramètre électrique, tel qu'une transmission de tension, de courant ou de puissance, du statut des bornes de sortie (6).

5. Unité d'alimentation électrique selon l'une quelconque des revendications précédentes, dans laquelle les données générées de manière externe sont des données provenant d'une base de données (11) connectée à l'unité d'alimentation électrique (1) par le biais d'une interface de réseau (12) de l'unité d'alimentation électrique (1).

6. Unité d'alimentation électrique selon l'une quelconque des revendications précédentes, dans laquelle les données générées dans l'unité d'alimentation électrique (1) sont des données provenant d'une base de données (11) dans l'unité d'alimentation électrique (1).

7. Unité d'alimentation électrique selon l'une quelconque des revendications précédentes, dans laquelle les données générées dans l'unité d'alimentation électrique (1) ou données générées de manière externe sont amenées à une unité d'intelligence artificielle, telle qu'un réseau formé, émettant un signal de sélection pour accorder la priorité à la première ou la deuxième boucle de commande (4, 5), respectivement.

8. Unité d'alimentation électrique selon la revendication 8, dans laquelle l'unité d'intelligence artificielle est positionnée dans l'unité d'alimentation électrique (1) ou dans laquelle l'unité d'intelligence artificielle est positionnée de manière externe et l'unité d'alimentation électrique (1) est connectée à l'unité d'intelligence artificielle par le biais d'une interface réseau (11) de l'unité d'alimentation électrique (1).

9. Unité d'alimentation électrique selon l'une quelconque des revendications précédentes, dans laquelle l'unité de commande de retour (2) est de plus agencée pour ajuster au moins une valeur de paramètre de commande de la boucle de commande (4, 5) à laquelle la priorité est accordée, de préférence également sur la base de données générées dans l'unité d'alimentation électrique (1) ou de données générées de manière externe amenées à l'unité d'alimentation électrique (1) .

10. Unité d'alimentation électrique selon l'une quelconque des revendications précédentes, qui est une alimentation en courant continu.

11. Unité d'alimentation électrique selon l'une quelconque des revendications précédentes, dans laquelle l'unité de commande de retour (2) comprend un algorithme de commande analogique ou numérique.

12. Analyseur de puissance comprenant une unité d'alimentation électrique (1) selon l'une quelconque des revendications 1-11.

13. Procédé pour faire fonctionner une unité d'alimentation électrique (1), de préférence pour un analyseur de puissance, comprenant :
- la commande de retour sélective d'un niveau de sortie d'une tension ou d'un niveau de sortie d'un courant vers des bornes de sortie (6) de l'unité d'alimentation électrique (1) sur une valeur préréglée,
- la détection du niveau de sortie réel de la tension et du courant, respectivement, pour la commande de retour sélective, et
- le fait d'accorder la priorité de manière autonome à une d'au moins une première boucle de commande (4) pour la commande du niveau de sortie du courant ou d'une deuxième boucle de commande (5) pour la commande du niveau de sortie de la tension, sur la base de données générées dans l'unité d'alimentation électrique (1) ou de données générées de manière externe amenées à l'unité d'alimentation électrique (1),
dans lequel la première boucle de commande (4) et la deuxième boucle de commande (5) sont toutes les deux actives et en fonctionnement, et
dans lequel l'accord de priorité signifie qu'une de la première boucle de commande (4) et de la deuxième boucle de commande (5) a plus de poids que l'autre, et ainsi, a plus d'influence que l'autre sur la commande du circuit de puissance par l'unité de commande de retour (2).

14. Procédé selon la revendication 13, comprenant en outre l'amenée à une unité d'intelligence artificielle, telle qu'un réseau formé, des données générées dans l'unité d'alimentation électrique (1) ou données générées de manière externe et l'émission d'un signal de sélection pour accorder la priorité à la première ou à la deuxième boucle de commande (4, 5), respectivement.

15. Procédé selon la revendication 13 ou 14, comprenant en outre l'ajustement d'au moins une valeur de paramètre de commande de la boucle de commande (4, 5) à laquelle la priorité est accordée, de préférence également sur la base de données générées dans l'unité d'alimentation électrique (1) ou de données générées de manière externe amenées à l'unité d'alimentation électrique (1).
